(19) **Europäisches Patentamt / European Patent Office / Office européen des brevets**

(11) **EP 2 727 132 B1**

(12) # EUROPEAN PATENT SPECIFICATION

(45) Date of publication and mention
of the grant of the patent:
**03.02.2016 Bulletin 2016/05**

(51) Int Cl.:
*H01L 21/00* *(2006.01)*      *G01F 1/20* *(2006.01)*

(21) Application number: **12805169.5**

(22) Date of filing: **29.06.2012**

(86) International application number:
**PCT/US2012/045071**

(87) International publication number:
**WO 2013/003789 (03.01.2013 Gazette 2013/01)**

(54) **HERMETICALLY SEALED MEMS DEVICE WITH A PORTION EXPOSED TO THE ENVIRONMENT WITH VERTICALLY INTEGRATED ELECTRONICS**

HERMETISCH ABGEDICHTETE MEMS-VORRICHTUNG MIT EINEM HERAUSRAGENDEN TEIL MIT VERTIKAL INTEGRIERTER ELEKTRONIK

DISPOSITIF MEMS SCELLÉ HERMÉTIQUEMENT AVEC UNE PARTIE EXPOSÉE À L'ENVIRONNEMENT POSSÉDANT UNE ÉLECTRONIQUE INTÉGRÉE VERTICALEMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.06.2011   US 201161502616 P**
**28.06.2012   US 201213536798**

(43) Date of publication of application:
**07.05.2014   Bulletin 2014/19**

(73) Proprietor: **InvenSense, Inc.**
**Sunnyvale, California 94089 (US)**

(72) Inventors:
• **SEEGER, Joseph**
**Menlo Park, CA 94025 (US)**
• **TCHERTKOV, Igor**
**San Jose, CA 95130 (US)**
• **AKYOL, Hasan**
**Mountain View, CA 94043 (US)**

• **YARALIOGLU, Goksen, G.**
**Mountain View, CA 94041 (US)**
• **NASIRI, Steven, S.**
**Saratoga, CA 95070 (US)**
• **GURIN, Ilya**
**Mountain View, CA 94043 (US)**

(74) Representative: **Miller, James Lionel Woolverton**
**Kilburn & Strode LLP**
**20 Red Lion Street**
**London WC1R 4PJ (GB)**

(56) References cited:
EP-A2- 1 860 417          US-A1- 2004 183 189
US-A1- 2005 276 726    US-A1- 2006 208 326
US-A1- 2006 208 326    US-A1- 2006 260 401
US-A1- 2007 082 422    US-A1- 2010 013 501
US-A1- 2010 171 153    US-A1- 2010 207 217
US-A1- 2010 314 669    US-A1- 2010 314 669

**Description**

CROSS-REFERENCE TO RELATED APPLICATION

This application claims the benefit of U.S. Provisional Patent Application No. 61/502,616, filed on June 29, 2011, entitled "HERMETICALLY SEALED MEMS DEVICE WITH A PORTION EXPOSED TO THE ENVIRONMENT AND WITH VERTICALLY INTEGRATED ELECTRONICS". This application is related to U.S. Provisional Patent Application No. 61/502,603 filed 6/29/2011, docket # IVS-154PR (5027PR), entitled "DEVICES AND PROCESSES FOR CMOS-MEMS INTEGRATED SENSORS WITH PORTION EXPOSED TO ENVIRONMENT," and U.S. Patent Application docket # IVS-154 (5027P), entitled "PROCESS FOR A SEALED MEMS DEVICE WITH A PORTION EXPOSED TO THE ENVIRONMENT," filed concurrently herewith and assigned to the assignee of the present invention.

FIELD OF THE INVENTION

The present invention relates to Microelectromechanical Systems (MEMS) devices, and more particularly, to MEMS devices that sense pressure.

BACKGROUND

MEMS devices comprise a moveable microstructure that moves in response to forces such as inertial, electrostatic, magnetic or differential pressure. There is a strong need for a cost-effective solution that improves the detection of forces such as pressure. The present invention addresses such a need.
EP 1860417 discloses a pressure sensor manufactured by joining two wafers, the first wafer comprising CMOS circuitry and the second being an SOI wafer. A recess is formed in the top material layer of the first wafer, which is covered by the silicon layer of the second wafer to form a cavity. Part or all of the substrate of the second wafer is removed to forming a membrane from the silicon layer. The second wafer is electrically connected to the circuitry on the first wafer.

SUMMARY OF THE INVENTION

A system and method for providing a MEMS device with integrated electronics are disclosed. According to an aspect, there is provided a microelectromechanical systems (MEMS) device according to claim 1. In a first example, the MEMS device comprises an integrated circuit substrate and a MEMS subassembly coupled to the integrated circuit substrate. The integrated circuit substrate includes at least one circuit coupled to at least one fixed electrode. The MEMS subassembly includes at least one standoff formed by a lithographic process, a flexible plate with a top surface and a bottom surface, and a MEMS electrode coupled to the flexible plate and electrically coupled to the at least one standoff. A force acting on the flexible plate causes a change in a gap between the MEMS electrode and the at least one fixed electrode.
In a second example, the method comprises providing an integrated circuit substrate and coupling a MEMS subassembly to the integrated circuit substrate. The integrated circuit substrate includes at least one circuit coupled to at least one fixed electrode. The MEMS subassembly includes at least one standoff formed by a lithographic process, a flexible plate with a top surface and a bottom surface, and a MEMS electrode coupled to the flexible plate and electrically coupled to the at least one standoff. A force acting on the flexible plate causes a change in a gap between the MEMS electrode and the at least one fixed electrode.

BRIEF DESCRIPTION OF THE DRAWINGS

The accompanying figures illustrate several embodiments of the invention and, together with the description, serve to explain the principles of the invention. One of ordinary skill in the art will recognize that the particular embodiments illustrated in the figures are merely exemplary, and are not intended to limit the scope of the present invention.

Figure 1 illustrates a cross-section view of a MEMS device in accordance with a first embodiment.
Figure 2 illustrates a cross-section view of a MEMS device in accordance with a second embodiment.
Figure 3 illustrates a cross-section view of a MEMS device in accordance with a third embodiment.
Figure 4 illustrates a cross-section view of a MEMS device in accordance with a fourth embodiment.
Figure 5 illustrates a cross-section view of a MEMS device in accordance with a fifth embodiment.
Figure 6 illustrates a cross-section view of a MEMS device in accordance with a sixth embodiment.
Figure 7 illustrates a cross-section view of a MEMS device in accordance with a seventh embodiment.

Figure 8 illustrates a cross-section view of a MEMS device in accordance with an eighth embodiment.
Figure 9 illustrates operation of a MEMS device in accordance with a ninth embodiment.
Figure 10 illustrates a graph displaying variation of flexible plate deflection as a function of ambient temperature.
Figure 11 illustrates a cross-section view of a MEMS device in accordance with a tenth embodiment.
Figure 12 illustrates operation of the MEMS device in accordance with the tenth embodiment.
Figure 13 illustrates a cross-section view of the MEMS device with a dielectric in the sealed cavity in an embodiment.
Figure 14 illustrates an embodiment of a cross-section view of the MEMS device with flexible plate decoupled from the handle substrate.

DETAILED DESCRIPTION

The present invention relates to Microelectromechanical Systems (MEMS) devices, and more particularly, to MEMS devices that sense pressure. The following description is presented to enable one of ordinary skill in the art to make and use the invention and is provided in the context of a patent application and its requirements. Various modifications to the described embodiments and the generic principles and features described herein will be readily apparent to those skilled in the art.

A system and method in accordance with the present invention provides force sensitive and force exerting MEMS devices with integrated electronics. By bonding an integrated circuit substrate that includes at least one fixed electrode to a MEMS subassembly that includes a lithographically formed standoff and a flexible plate with coupled MEMS electrode, a sealed cavity is formed with a reference pressure. Accordingly, a force acting on the flexible plate causes a deflection of the flexible plate and in turn, causes a change in a gap size formed by the sealed cavity between the MEMS electrode and the at least one fixed electrode.

The flexible plate of the MEMS devices deforms and deflects due to a variety of external forces acting on the portion of the flexible plate that is disposed externally and subject to the ambient surrounding environment. These external forces include but are not limited to pressure differences between the reference pressure and a pressure of the ambient surrounding environment, shear forces acting on the flexible plate, and other forces acting on the flexible plate via micro-flow and acceleration exertions.

Additionally, a system and method in accordance with the present invention describes a class of MEMS devices, sensors, and actuators including but not limited to pressure sensors, self-testing pressure sensors, accelerometers, force sensors, shear sensors, fluidic sensors, and micro-speakers that are hermetically sealed and bonded to integrated circuits, that use capacitive sensing and electrostatic actuation, and that have a flexible plate between the hermetically sealed cavity and the surrounding environment to allow the device to interact with the surrounding environment.

Features that enhance performance of the MEMS devices include but are not limited to electrode configurations for detecting and rejecting variations of gap between the MEMS electrode and the fixed electrode of the integrated circuit substrate, pressure sensor offset temperature dependence canceling techniques, pressure sensor self-testing and self-calibrating techniques, and pressure sensor particle filters that eliminate undesirable environmental factors.

To describe the features of the present invention in more detail, refer now to the following description in conjunction with the accompanying figures.

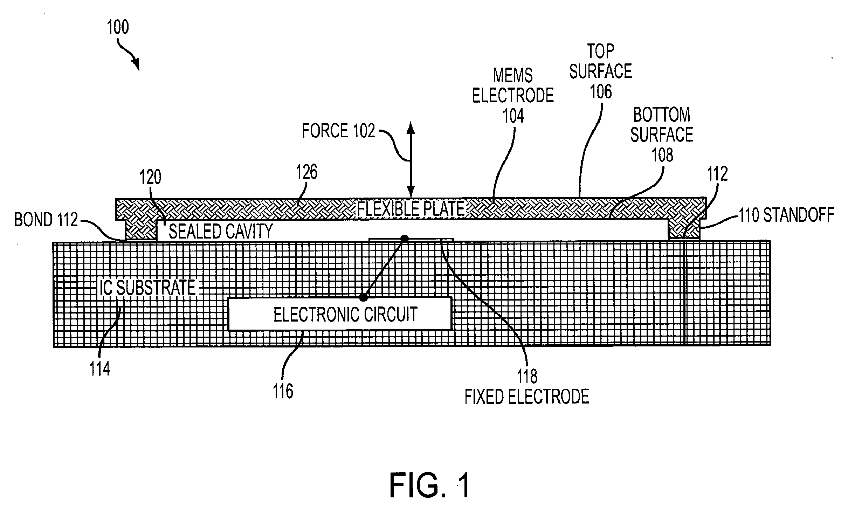

Figure 1 illustrates a cross-section view of a MEMS device 100 in accordance with a first example. The MEMS device 100 includes an integrated circuit substrate 114, an electronic circuit 116 coupled to the integrated circuit substrate 114, and a fixed electrode 118 coupled to the integrated circuit substrate 114. In one example, the integrated circuit substrate 114 comprises CMOS circuitry. The MEMS device 100 also includes a MEMS subassembly that comprises a MEMS electrode 104, a flexible plate 126 coupled to the MEMS electrode 104, and at least one standoff 110 coupled to the MEMS electrode 104. The flexible plate 126 comprises a top surface 106 and a bottom surface 108. The MEMS subassembly is bonded to the integrated circuit substrate 114 via a bond 112 which forms a sealed cavity 120.

In Figure 1, the sealed cavity 120 boundaries are defined by the integrated circuit substrate 114, the at least one standoff 110, and a portion of the bottom surface 108 of the flexible plate 126. In one example, the sealed cavity 120 contains gas with a reference pressure ($P_{ref}$). The top surface 106 of the flexible plate 126 is exposed to an ambient environment including but not limited to the Earth's atmosphere with an ambient pressure ($P_{amb}$).

The gap between the MEMS electrode 104 and the fixed electrode 118 is determined by the at least one standoff 110 height. The combination of the MEMS electrode 104 and the fixed electrode 118 forms a capacitor. Deformation of the flexible plate 126 due to a force 102, including but not limited to pressure changes, causes changes in the gap between the MEMS electrode 104 and the fixed electrode 118. These changes in the gap in turn cause capacitance changes within the capacitor that are measured by a capacitive measurement process. In one example, the capacitive measurement process includes connecting the capacitor to the integrated circuit substrate 114 with the embedded electronic circuit 116 then measuring a capacitance to indicate the amount of plate deformation resulting from the force 102.

In one example, the flexible plate 126 is formed on a device layer such as a single crystal silicon device layer and is made from doped Silicon (Si) with a thickness range including but not limited to 1 micrometer (um) to 100 um. In this example, the doped Si enables the flexible plate 126 to also serve as the MEMS electrode 104. The flexible plate 126 has at least one standoff 110 lithographically formed on its bottom surface 108. In this example, the fixed electrode 118 is formed from a top metal layer of the CMOS integrated circuit substrate 114. One of ordinary skill in the art readily recognizes that the flexible plate 126 can be made to be responsive to various forces.

The at least one standoff 110 is bonded to the integrated circuit substrate 114 by the bond 112 that is conductive to create an electrical connection between the integrated circuit substrate 114 and the MEMS electrode 104. One of ordinary skill in the art readily recognizes that the bond 112 can be a variety of different conductive bonds including but not limited to an aluminum-germanium eutectic bond.

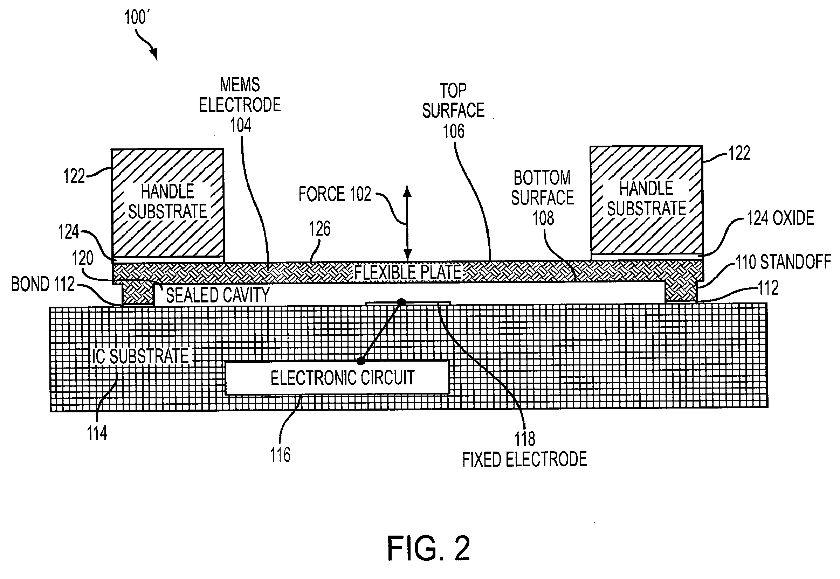

Figure 2 illustrates a cross-section view of a MEMS device 100' in accordance with a second example. The MEMS device 100' of Figure 2 resembles the MEMS device 100 of Figure 1, but also includes a handle substrate 122 coupled to the flexible plate 126 via an oxide 124 to form an opening that leaves the top surface 106 of the flexible plate 126 exposed to an ambient environment. In one example, a micro-fluidic channel is formed by the opening created by the handle substrate 122. The flexible plate 126 forms the floor of the micro-fluidic channel. Viscous and other forces exerted by running fluid on the flexible plate 126 causes deformation of the flexible plate 126 which is in turn measured by the aforementioned capacitive measurement process.

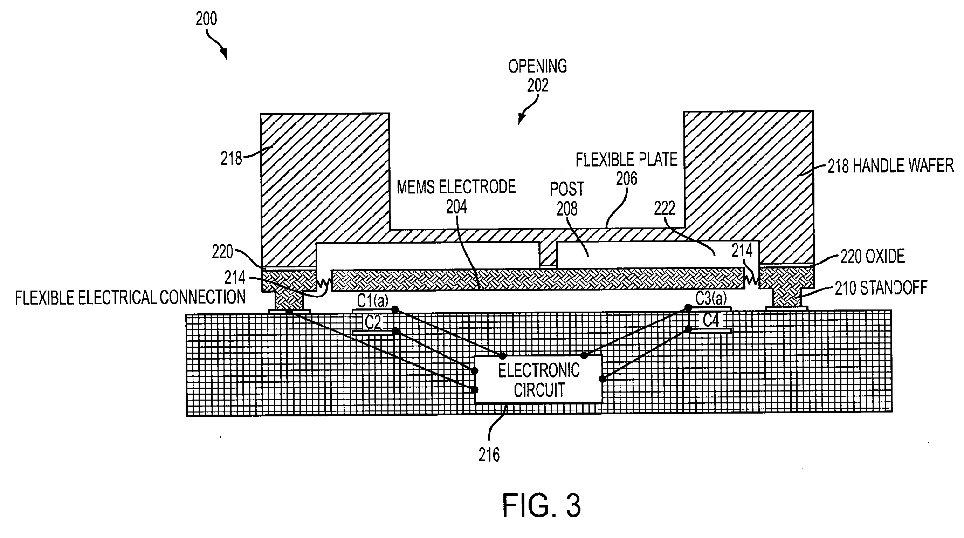

Figure3 illustrates a cross-section view of a MEMS device 200 in accordance with a third example. The MEMS device 200 of Figure 3 resembles the MEMS device 100' of Figure 2, but also includes a flexible electrical connection 214 that connects the at least one standoff 210 to the MEMS electrode 204 and a post 208 that connects the flexible plate 206 to the MEMS electrode 204. In an example, electrode 204 may move in response due to pressure difference between the opening 202 and the sealed cavity 222. In another example, electrode 204 may move in response due to the inertial forces acting on the electrode 204. Additionally, in Figure 3, the electronic circuit 216 is connected to four electrodes to create the four capacitors C1(a), C3(a), C2, and C4 utilized for the pressure sensing or acceleration sensing.

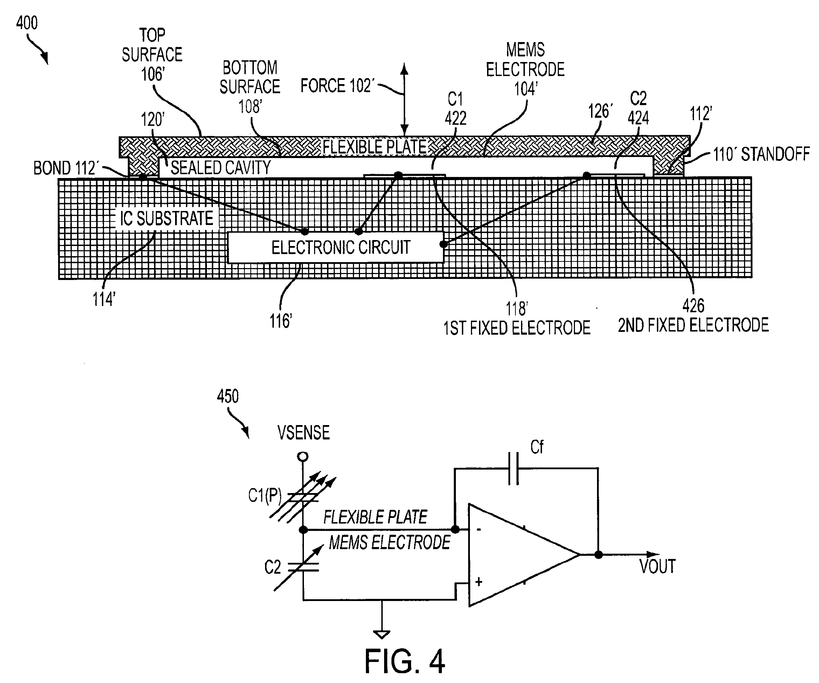

Figure 4 illustrates a cross-section view of a MEMS device 400 in accordance with a fourth example. The MEMS device 400 includes an integrated circuit substrate 114', an electronic circuit 116' coupled to the integrated circuit substrate 114', and both a first fixed electrode 118' and a second fixed electrode 426 coupled to the integrated circuit substrate 114'. The MEMS device 400 also includes a MEMS subassembly that comprises a MEMS electrode 104', a flexible plate 126' coupled to the MEMS electrode 104', and at least one standoff 110' coupled to the MEMS electrode 104'. In one example, the flexible plate 126' comprises a top surface 106' and a bottom surface 108'. The MEMS subassembly is bonded to the integrated circuit substrate 114' via a bond 112' which forms a sealed cavity 120'.

The MEMS device 400 of Figure 4 resembles the MEMS device 100 of Figure 1 but has been configured to enable differential sensing. The first fixed electrode 118' is disposed under a moving portion of the flexible plate 126'. The gap between the moving portion and the first fixed electrode 118' is nominally defined by the height of the at least one standoff 110', but changes due to pressure differences between the sealed cavity 120' and the ambient surrounding environment. The second fixed electrode 426 is disposed under a reference portion of the flexible plate 126' which is located substantially closer to the at least one standoff 110'. The gap between the second fixed electrode 426 and the reference portion of the flexible plate 126' is also nominally defined by the height of the at least one standoff 110', but is less sensitive to external pressure in comparison to the moving portion.

In Figure 4, the first fixed electrode 118' and the moving portion of the flexible plate 126' form a first capacitor $(C_1)$ 422 and the second fixed electrode 426 and the reference portion of the flexible plate 126' form a second capacitor $(C_2)$ 424. The electronic circuit 116' measures a difference between the first and the second capacitors 422-424 in response to the force 102' including but not limited to pressure changes. In one example, the electronic circuit 116' is insensitive to manufacturing variations of the height of the at least one standoff 110'. In this example, the electronic circuit 116', shown in the bottom part of Figure 4, is designed using switched-capacitor techniques and is a half-bridge arrangement 450 that senses the difference between the two capacitors 422-424.

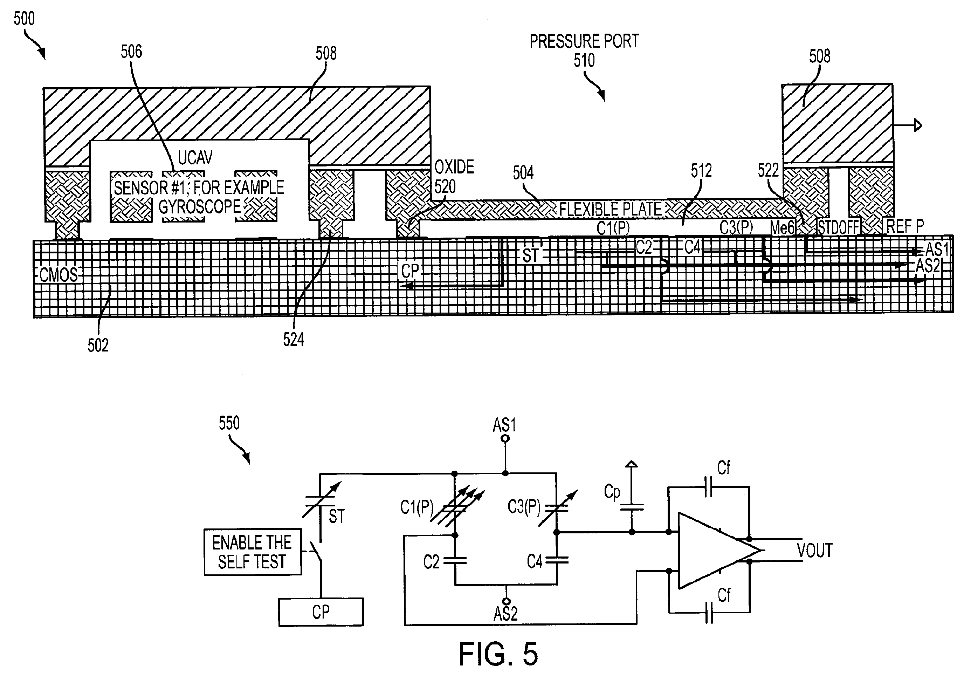

Figure 5 illustrates a cross-section view of a MEMS device 500 in accordance with a fifth example. The MEMS device 500 includes a CMOS integrated circuit substrate 502, a flexible plate 504 coupled to the CMOS substrate 502, a second MEMS device 506 coupled to the CMOS substrate 502, a handle substrate 508 coupled to the flexible plate 504, and a pressure port 510 located above the flexible plate 504. A portion of the handle substrate 508 is opened to form the pressure port 510 and expose the flexible plate 504 to the environment. The second MEMS device 506 is formed in the device layer and horizontally integrated with the pressure port 510. The second MEMS device 506 is covered by the handle substrate 508 and flexible plate 504. Handle substrate 508 may be connected ground potential through wire bond or through-silicon via (TSV) or other similar techniques. One of ordinary skill in the art readily recognizes that the second MEMS device 506 can be a variety of devices including but not limited to a gyroscope or accelerometer.

In an example, sealed cavity 512 may be formed by the flexible plate 504, standoffs 520 and 522 and CMOS substrate 502 and sealed at a certain pressure. A second sealed cavity enclosing second MEMS device 506 may be separately sealed at a different pressure than the sealed cavity 512. In an example, the sealed cavity 512 and the second sealed cavity may be sealed at the same pressure by opening a portion of the standoffs. In an example, sealed cavity 512 is bounded by the standoffs 520 and 522. In another example, a portion of standoff 520 is opened (not shown in Fig. 5) such that sealed cavity is bound by standoffs 522 and 524. In another example, a portion of standoff 520 and 524 are opened to extend sealed cavity 512 to include the second sealed cavity.

The MEMS device 500 of Figure 5 resembles the MEMS device 400 of Figure 4 but also includes two additional capacitors C2 and C4 formed in the CMOS integrated circuit substrate 502. In one example, the two additional capacitors C2 and C4 are formed by two metal layers used in a CMOS process. In another example, capacitor C2 is disposed right below capacitor C1 (P) and capacitor C4 is disposed right below capacitor C3(P). In this example, all four capacitors C1 (P), C2, C3(P), and C4 are designed to be equal at a particular value of $P_{amb}$. One of ordinary skill in the art readily recognizes that the four capacitors can be arranged in a variety of different configurations.

The electronic circuit, embedded within the CMOS integrated circuit substrate 502 and shown in the bottom part of Figure 5, is designed to electrically connect these four capacitors C1 (P), C2, C3(P), and C4 to form a capacitive bridge circuit 550. Driving potentials are applied to terminals of the capacitive bridge circuit 550 labeled AS1-ACT and AS2-Me5. Bridge output terminals are labeled Me6-PM2 and Me6-PM1. The capacitive bridge circuit 550 outputs a signal that is proportional to the capacitance difference according to the following equation: C1(P) - C2 - C3(P) + C4. As a result, the output of the capacitive bridge circuit 550 changes due to pressure differences across the flexible plate 504. In another embodiment, the electronic circuit is designed and implemented as a switched-capacitor circuit.

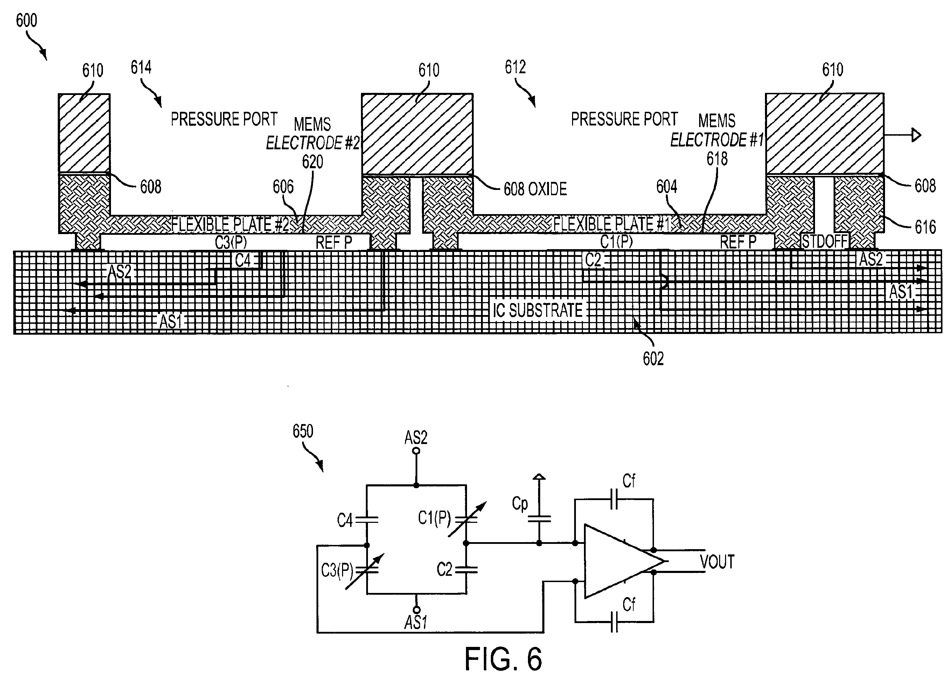

Figure 6 illustrates a cross-section view of a MEMS device 600 in accordance with a sixth example. The MEMS device 600 includes an integrated circuit substrate 602 coupled to both a first flexible plate 604 and a second flexible plate 606, a first MEMS electrode 618 coupled to the first flexible plate 604, a second MEMS electrode 620 coupled to the second flexible plate 606, a handle substrate 610 coupled to both the first and second flexible plates 604-606 via an oxide layer 608 and at least one standoff 616, a first pressure port 612 formed by an opening in the handle substrate and located above the first flexible plate 604, and a second pressure port 614 located above the second flexible plate 606.

The electronic circuit, embedded within the integrated circuit substrate 602 and shown in the bottom part of Figure 6, is designed using switched-capacitor techniques as two identical half-bridge arrangements 650 disposed side by side. As a result, in this electronic circuit, all four capacitors C1 (P), C2, C3(P), and C4 are configured in a full bridge circuit.

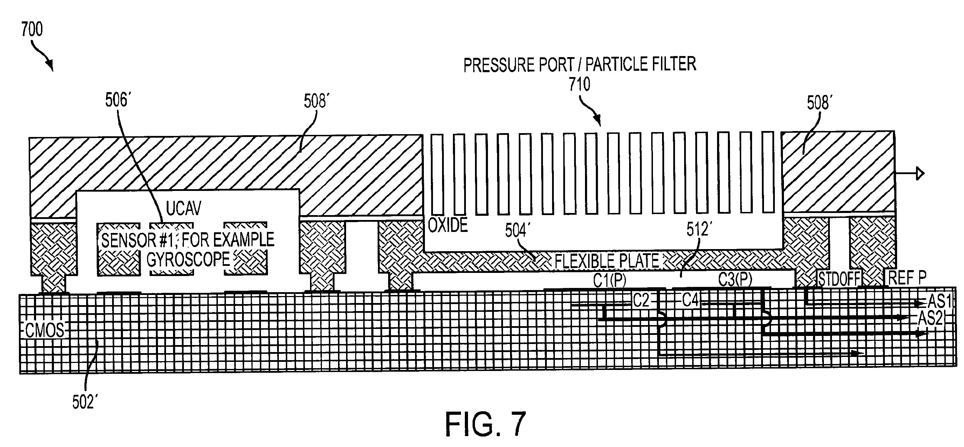

Figure 7 illustrates a cross-section view of a MEMS device 700 in accordance with a seventh example. The MEMS device 700 of Figure 7 resembles the MEMS device 500 of Figure 5, but includes a particle filter 710 formed in the handle substrate to enhance environmental protection of the MEMS device 700. The particle filter 710 helps eliminated undesirable environmental factors from disturbing the operation and functionality of the MEMS device 700. In one example, the particle filter 710 is formed by etching long and narrow channels with varying cross-sections including but not limited to approximately 2 $\mu$m x 2 $\mu$m.

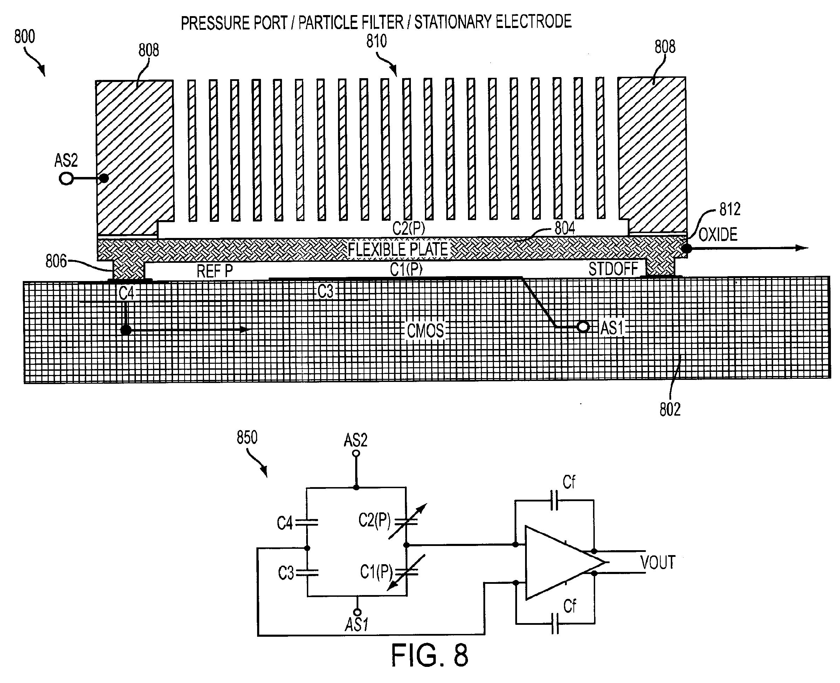

Figure 8 illustrates a cross-section view of a MEMS device 800 in accordance with an eighth example. Figure 8 includes an electronic circuit diagram 850 describing the circuitry configuration of the MEMS device 800. The MEMS device 800 includes a CMOS substrate 802, a flexible plate 804 coupled to the CMOS substrate 802 via at least one standoff 806 forming a sealed cavity, a handle substrate 808 coupled to the flexible plate 804 via an oxide layer 812, and a particle filter 810 formed in the handle substrate 808 located above the flexible plate 804.

In one example, particle filter 810 is used as a stationary electrode. In Figure 8, the particle filter 810 is connected to a driving node of the CMOS substrate 802 forming two capacitors C1 (P) and C2(P) that are responsive to pressure difference variations by using the particle filter 810 as a second fixed electrode disposed above a top surface of the flexible plate 804. The two variable capacitors C1 (P) and C2(P) respond to pressure difference variations in exact opposite ways. As a result, if one of the capacitors increases its value, the other capacitor decreases its value which affords full differential pressure sensing that includes increased (doubled) sensitivity.

In one example, channels of the particle filter 810 are partially filled with a soft protective gel or oil that are kept in place by an adhesive or surface tension forces. The soft protective gel or oil acts as an impermeable barrier against particles and moisture while still transmitting pressure difference variations without any significant attenuation. One of ordinary skill in the art readily recognizes that the channels of the particle filter 810 may be partially filled at varying levels and by a variety of materials.

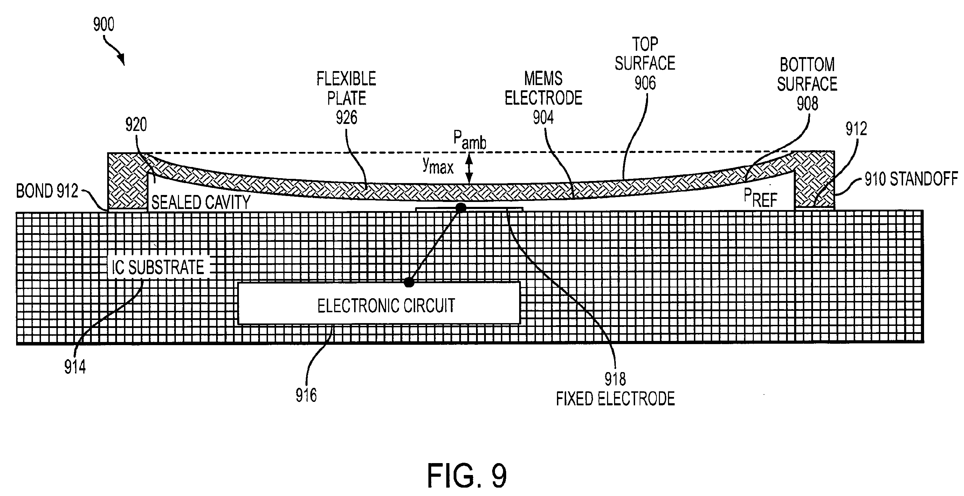

Figure 9 illustrates operation of a MEMS device 900 in accordance with a ninth example. The MEMS device 900 includes an integrated circuit substrate 914, an electronic circuit 916 coupled to the integrated circuit substrate 914, and a fixed electrode 918 coupled to the integrated circuit substrate 914. The MEMS device 900 also includes a MEMS subassembly that comprises a MEMS electrode 904, a flexible plate 926 coupled to the MEMS electrode 904, and at least one standoff 910 coupled to the MEMS electrode 904. The flexible plate 926 comprises a top surface 906 and a bottom surface 908. The MEMS subassembly is bonded to the integrated circuit substrate 914 via a bond 912 which forms a sealed cavity 920.

The flexible plate 926 is deformed due to an ambient environment pressure ($P_{amb}$) being greater than a reference pressure ($P_{ref}$) or a $P_{amb} > P_{ref}$ condition. These two pressures are separated by the flexible plate 926. In one example, the flexible plate 926 is thin. One of ordinary skill in the art readily recognizes that the thinness of the flexible plate 926 can be of varying degrees.

The sealed cavity 920 disposed on one side of the flexible plate 926 is sealed during factory manufacturing at a reference pressure of $P_{ref}$ including but not limited to 0.1 to 100 millibar (mbar) or 10.1 Pascal (Pa) to 10.1 kPa. The other side of the flexible plate 926 is exposed to an ambient environment pressure of $P_{amb}$. In one example, $P_{amb}$ is atmospheric pressure which at sea level is approximately 1 atm or 101 kPa. One of ordinary skill in the art readily recognizes that $P_{amb}$ changes as a result of meteorological conditions and as a function of elevation.

The flexible plate 926 deforms due to a pressure difference $P_{amb}$ - $P_{ref}$ and a maximal deflection point of the flexible plate 926 is described by the following equation, where $k_{eff}$ is an effective stiffness of the flexible plate 926:

$$y_{max} = \frac{1}{k_{eff}}\left(P_{amb} - P_{ref}\right) \quad (1).$$

In one embodiment, the effective stiffness of a square membrane with fixed edges, thickness of h, and side length of b is described by the following equation, where E is the Young's modulus:

$$k_{eff} = \frac{E\,h^3}{(.0138)b^4} \qquad (2).$$

The flexible plate 926 deflection also changes due to a temperature variation of the structural material stiffness of the flexible plate 926 and due to a temperature variation of the reference pressure. In one embodiment, there is a vacuum in the sealed cavity 920 and so the reference pressure $P_{ref}$ is 0. In this embodiment, the deflection of the flexible plate 926 is influenced only by a temperature variation of the structural material stiffness of the flexible plate 926. One of ordinary skill in the art readily recognizes that most materials become softer with temperature rises and so the deflection of the flexible plate 926 will increase with temperature.

In another embodiment, the flexible plate 926 is made from a very soft material, moves essentially as a piston, and the sealed cavity 920 is sealed while containing gas at a reference pressure $P_{ref}$. In this embodiment, when temperature rises, the pressure exerted by the gas on the flexible plate 926 rises as well which pushes the flexible plate 926 away from the integrated circuit substrate 914. This results in a reduction in the deflection of the flexible plate 926.

In another embodiment, the sealed cavity 920 is sealed while containing gas at a particular pressure that results in the deflection of the flexible plate 926 being insensitive to temperature variation due to a canceling of two effects. The first effect of a temperature variation of the deflection of the flexible plate 926 is described by the following equation:

$$\frac{dy_{max}}{dT} = \frac{1}{k_{eff}}\left(-\frac{dk_{eff}}{dT}\frac{1}{k_{eff}}\left(P_{amb} - P_{ref}\right) - \frac{dP_{ref}}{dT}\right) \quad (3).$$

According to the ideal gas law, the second effect of a pressure in the sealed cavity 920 is proportional to an absolute temperature and is described by the following equation:

$$\frac{dP_{ref}}{dT} = \frac{P_{ref}}{T} \quad (4).$$

At a specific reference pressure, these two effects cancel each other out resulting in a deflection of the flexible plate 926 that is temperature independent. This specific reference pressure is described by the following equation:

$$P_{ref} = P_{amb}\frac{-\frac{dE}{dT}\frac{T}{E}}{\left(1 - \frac{dE}{dT}\frac{T}{E}\right)} \quad (5).$$

In one embodiment that uses a silicon material, the typical variation of Young's modulus is -40 ppm/K. In this embodiment, at a temperature of T = 300 Kelvin (K), the reference pressure $P_{ref}$ that provides a cancellation of these two effects is approximately described by the following equation:

$$P_{ref} = 0.0118 \cdot P_{amb} \quad (6).$$

As a result, a MEMS device utilizing equation (6) to cancel the two aforementioned effects does not require independent temperature measurement by an on-board temperature sensor. One of ordinary skill in the art readily recognizes that a variety of temperatures and varying materials will result in changes to these aforementioned equations.

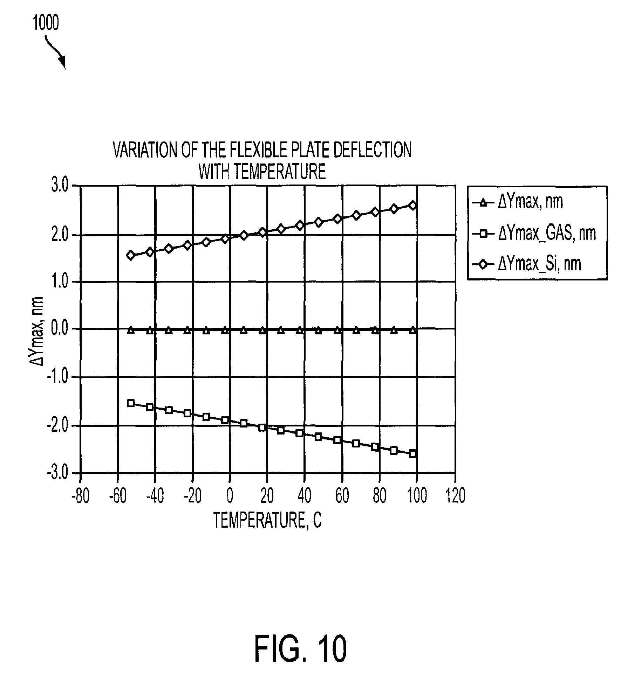

Figure 10 illustrates a graph 1000 displaying variation of flexible plate defection as a function of ambient temperature. The graph 1000 is computed using aforementioned equation (3). In the graph 1000, $\Delta ymax\_Si$ plots contribution from a Si Young modulus only, $\Delta ymax\_gas$ plots contribution only from gas in the sealed cavity, and $\Delta ymax$ plots variation of the flexible plate deflection in a perfectly compensated pressure sensor prescribed by aforementioned equation (6).

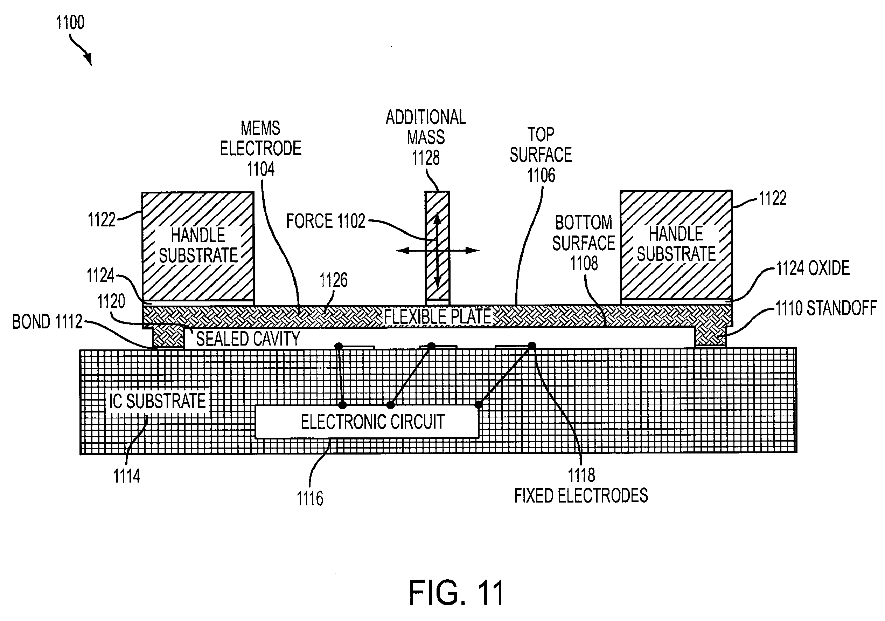

Figure 11 illustrates a cross-section view of a MEMS device 1100 in accordance with a tenth embodiment. The MEMS device 1100 includes an integrated circuit substrate 1114, an electronic circuit 1116 coupled to the integrated circuit substrate 1114, and at least one fixed electrode 1118 coupled to the integrated circuit substrate 1114. The MEMS device 1100 also includes a MEMS subassembly that comprises a MEMS electrode 1104, a flexible plate 1126 coupled to the MEMS electrode 1104, and at least one standoff 1110 coupled to the MEMS electrode 1104.

The flexible plate 1126 comprises a top surface 1106 and a bottom surface 1108. The MEMS subassembly is bonded to the integrated circuit substrate 1114 via a bond 1112 which forms a sealed cavity 1120. A handle substrate 1122 is bonded to the flexible plate 1126 via an oxide layer 1124. An additional mass 1128 is also coupled to the top surface 1106 of the flexible plate 1126 to enable sensing of additional forces. In one embodiment, these additional forces include but are not limited to accelerations parallel and normal to the flexible plate 1126 and shear forces. In another embodiment, the additional mass 1128 is coupled to a joystick to enable tracking of joystick motion.

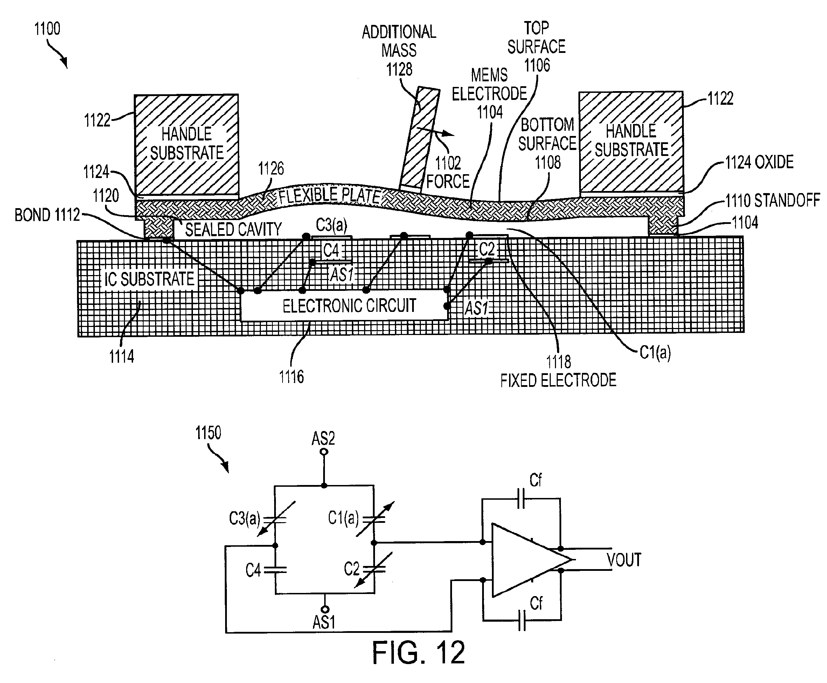

Figure 12 illustrates operation of the MEMS device 1100 in accordance with the tenth example. Figure 12 includes an electronic circuit diagram 1150 describing the circuitry configuration of the MEMS device 1100. Fig. 12 shows motion of the additional mass 1128 in a first direction parallel to the integrated circuit substrate 1114. The flexible plate 1126 is deformed due to an application of shearing forces.

In one example, three fixed electrodes are disposed under the flexible plate 1126: a first fixed electrode disposed under a middle portion of the flexible plate 1126, a second fixed electrode disposed to the left of the first fixed electrode, and a third fixed electrode disposed symmetrically to the right of the first fixed electrode. In this embodiment, shear forces cause capacitance of the second fixed electrode and the third fixed electrode to change oppositely, i.e. when the capacitance of the second fixed electrode increases the capacitance of the third fixed electrode decreases. In this example, normal forces cause all capacitance to change (i.e. increase or decrease) similarly. In another example, four fixed electrodes are disposed under the flexible plate 1126 on the CMOS substrate to measure motion normal to the substrate and motion in a first direction parallel to the substrate and motion in a second direction parallel to the substrate and orthogonal to the first direction.

Electrostatic actuation of the aforementioned MEMS devices is enabled by forming at least one more electrode on the integrated circuit substrate. This self-testing feature can also be used for self-calibration of the device at the factory, which lowers the cost of testing by eliminating the need for external pressure chambers. Electrostatic actuation of the flexible plate can be used for self-testing and self-calibration of the MEMS device and can be used to create a variety of devices including but not limited to micro-speakers, micro-mirrors, and MEMS devices that modulate light.

Referring back to Figure 5, the at least one more electrode is labeled ST for self-testing and is coupled to the CMOS substrate 502. In one embodiment, a voltage of 25V is applied to the at least one more ST electrode during self-testing. One of ordinary skill in the art readily recognizes that this voltage can be generated by a variety of methodologies including but not limited to a charge pump (CP) coupled to the CMOS substrate 502 in Figure 5. During this self-testing, an attractive electrostatic force is developed and applied to the flexible plate causing the flexible plate to deflect toward the fixed electrode in a similar fashion as an additional external pressure would.

The resulting function and emulated pressure is used for the self-testing of the pressure sensor MEMS device and is described by the following equation, where $P_{st}$ is a self-testing pressure, $F_{st}$ is a self-testing force, $A_{memb}$ is an area of the flexible plate, $A_{st}$ is an area of the self-testing electrode ST, $\varepsilon$ is dielectric permittivity (e.g. 8.85e-12F/m for vacuum); $V_{st}$ is self-testing potential, g is gap between the bottom of the reference sealed cavity/chamber and flexible plate, and k is a coefficient taking into account that the flexible plate bends as opposed to moving in a piston-like motion:

$$P_{ST} = \frac{F_{ST}}{A_{memb}} = \frac{k \cdot \dfrac{\varepsilon \cdot A_{ST} V_{ST}^2}{g^2}}{A_{memb}} = \frac{k\varepsilon \cdot A_{ST} V_{ST}^2}{A_{memb} \cdot g^2} \quad (7).$$

The aforementioned MEMS devices are utilized for a variety of applications including but not limited to pressure sensor devices, shear force sensor devices, and force exerting devices. As force exerting devices, the MEMS devices operate as micro-speakers, micro-mirrors, and micro-light modulating devices.

Additionally, disposing part of the flexible plate of these MEMS devices to the environment enables these MEMS devices to sense and actuate more than just pressure changes and variations. The MEMS devices described by Figure 3, Figure 11, and Figure 12 include signal processing schematics that are arranged to enable the MEMS device to function as an accelerometer. These schematics illustrate how a full capacitive Wheatstone bridge is formed to afford differential sensing and common mode rejections.

In another embodiment, the top surface of the flexible plate(s) of these aforementioned MEMS devices is coated with a chemical compound that is capable of absorbing selective gas or fluid species from the environment. Based upon deformations of the flexible plate resulting from these absorptions, the chemical compound coating enables the MEMS device for micro-balanced chemical sensing.

In one embodiment, the capacitive gap determined by the standoffs of the aforementioned MEMS devices is subject to manufacturing tolerances and variability that ordinarily lead to capacitance variations and therefore variability in sensor outputs. To combat this variability, in one embodiment, the aforementioned MEMS devices utilize common gap values for both capacitors C1 (P) and C3(P) by the implemented differential sensing.

One of the merits of any force sensing MEMS device is the ability to resolve very small variations in forces which result in very small $y_{max}$ variation sensing capabilities on the level of picometers ($\sim 10^{-12}$ m) and in very small C1(P) sensing on the level of a atto-Farads ($\sim 10^{-18}$ F). These small electrical signals are difficult to measure and are easily overwhelmed by various environmental factors. To combat these various environmental factors, in one embodiment, the aforementioned MEMS device utilize sensing nodes of the capacitive bridge formed by the first and second fixed electrodes which are electrically shielded from the environment by the conductive flexible plate and by the third and fourth fixed electrodes. The third and fourth fixed electrodes are the driven nodes of the capacitive bridge and carrying higher potentials than the first and second fixed electrodes. This results in the third and fourth fixed electrodes being less susceptible to these various environmental factors.

As above described, the system and method allow for more efficient and more accurate force sensing and force exerting MEMS devices that are capable of self-testing and self-calibrating. By coupling an integrated circuit substrate with a fixed electrode to a MEMS subassembly that includes a MEMS electrode coupled to a flexible plate, a hermetically sealed cavity/chamber is formed between the fixed electrode and the MEMS electrode that enables the sensing of various forces by a force responsive capacitive pressure sensor device. Thus, on one side of the flexible plate of this force responsive capacitive pressure sensor device is the hermetically sealed cavity/chamber and the other side is exposed to the surrounding ambient environment.

The at least one standoff formed on the MEMS subassembly determines the gap size of the hermetically sealed cavity/chamber and forms an electrical connection to the integrated circuit substrate. This capacitive pressure sensor can be integrated with other MEMS devices including but not limited to force-responsive devices on the same MEMS subassembly. This capacitive pressure sensor can also be integrated with other CMOS-based sensors including but not limited to temperature, light, and proximity sensors.

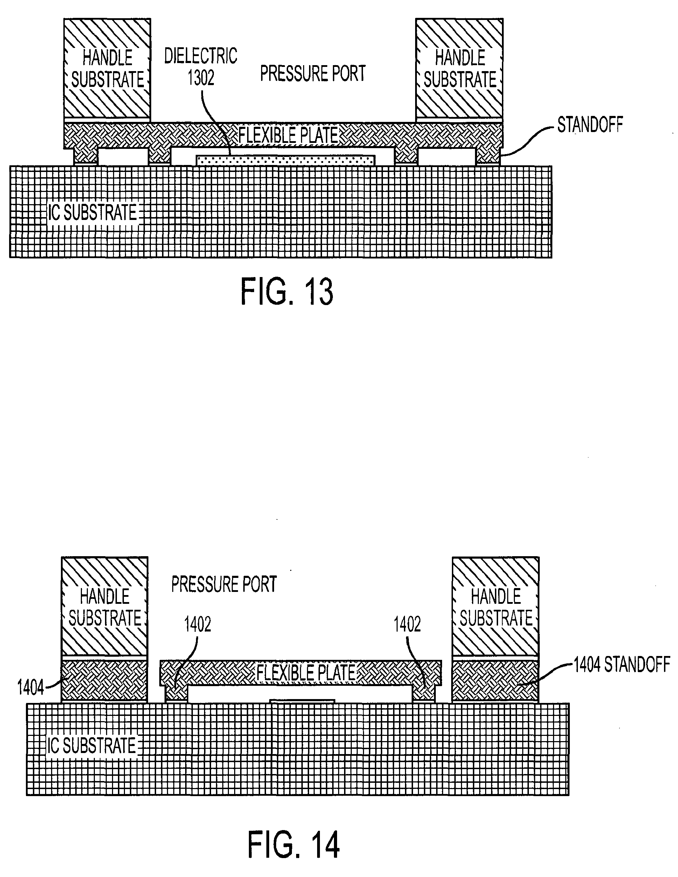

Figure 13 illustrates an embodiment of a cross-section view of a MEMS device with a dielectric in the sealed cavity. In an embodiment, dielectric 1302 may disposed over the fixed electrode, with thickness less than the height of the standoffs. The dielectric can be formed from, for instance, the passivation layer of the IC substrate. The dielectric functions as an over-travel stop, preventing the flexible plate from impacting the fixed electrode. In another embodiment, dielectric 1302 may disposed next to the fixed electrode without covering the fixed electrode. Dielectric 1302 enhances the electrostatic fields in the gap when the fixed electrode is disposed over the fixed electrode.

Figure 14 illustrates an embodiment of a cross-section view of a MEMS device with the flexible plate decoupled from the handle substrate. In an embodiment, the standoffs 1402 are uncoupled to the handle substrate and underneath the pressure port. Standoffs 1404 may provide hermitic seal for other MEMS devices(not shown in Fig. 14). A portion of the IC substrate exposed by the pressure port may require a passivation layer.

Although the present invention has been described in accordance with the embodiments shown, one of ordinary skill in the art will readily recognize that there could be variations to the embodiments. Accordingly, many modifications may be made by one of ordinary skill in the art without departing from the scope of the appended claims.

## Claims

1. A Microelectromechanical Systems (MEMS) device (100) comprising:

   an integrated circuit substrate (114);
   at least one electrode (118) disposed on the integrated circuit substrate;

a MEMS subassembly coupled to the integrated circuit substrate,
wherein the MEMS subassembly includes at least one standoff (110); a flexible plate (126) with a top surface (106) and a bottom surface (108);
a handle substrate (122),
wherein the flexible plate is formed on a device layer and is bonded to the handle substrate,
wherein an opening in the handle substrate exposes at least one portion of the top surface of the flexible plate to the ambient environment; and
a MEMS electrode (104) coupled to the flexible plate and electrically coupled to the at least one standoff, wherein a force (102) acting on the flexible plate causes a change in a gap between the MEMS electrode and the at least one electrode.

2. The MEMS device of (100) claim 1, wherein the at least one standoff (110) defines the gap between the MEMS electrode (104) and the at least one electrode (118).

3. The MEMS device (100) of claim 2, wherein at least one portion of the bottom surface (108) of the flexible plate is a surface of a sealed cavity (120) and at least one portion of the top surface (106) of the flexible plate is exposed to an ambient environment.

4. The MEMS device (100) of claim 2, wherein the force (102) results from a difference between ambient pressure and pressure in a sealed cavity (120).

5. The MEMS device (100) of claim 1, wherein the MEMS electrode (104) is a portion of the bottom surface (108).

6. The MEMS device (100) of claim 2, wherein the at least one standoff (110) is electrically coupled to the integrated circuit substrate (114).

7. The MEMS device (100) of claim 6, wherein the MEMS subassembly is bonded to the integrated circuit substrate (114) by an aluminum-germanium eutectic bond (112).

8. The MEMS device (100) of claim 1, wherein the MEMS electrode (104) is disposed over the at least one electrode (118) separated by the gap.

9. The MEMS device (100) of claim 1, wherein a sealed cavity (120) is formed by portions of the bottom surface (108), the at least one standoff (110), and the integrated circuit substrate (114).

10. The MEMS device (100) of claim 9, wherein the sealed cavity (120) is further formed by the bond (112) between the at least one standoff (110) and the integrated circuit substrate (114).

11. The MEMS device (100) of claim 9, wherein the sealed cavity (120) is sealed at a fixed pressure.

12. The MEMS device (100) of claim 1, wherein a portion of the bottom surface (108) is a surface of a sealed cavity (120).

13. The MEMS device (100) of claim 1, further comprising a dielectric layer (1302) disposed on the electrical circuit substrate (114), wherein distance between the MEMS electrode (104) and the dielectric layer is less than distance between the MEMS electrode and the at least one electrode (118).

14. The MEMS device (100) of claim 13, wherein the dielectric layer (1302) and the at least one electrode (118) are disposed laterally, or wherein the dielectric layer is disposed over the at least one electrode.

15. The MEMS device (100) of claim 1, wherein the at least one standoff (110) is bonded to the integrated circuit substrate (114) by an aluminum-germanium eutectic bond (112).

**Patentansprüche**

1. Mikroelektromechaniksystem (MEMS)-Vorrichtung (100) beinhaltend:

ein IC-Substrat (114);

zumindest eine Elektrode (118), die auf dem IC-Substrat angeordnet ist;
eine MEMS-Unterbaugruppe, die mit dem IC-Substrat gekoppelt ist, wobei die MEMS-Unterbaugruppe zumindest einen Abstandhalter (110) aufweist;
eine flexible Platte (126) mit einer oberen Fläche (106) und einer unteren Fläche (108);
ein Handhabungssubstrat (122),
wobei die flexible Platte auf einer Vorrichtungsschicht gebildet und an das Handhabungssubstrat gebunden ist,
wobei eine Öffnung in dem Handhabungssubstrat zumindest einen Abschnitt der oberen Fläche der flexiblen Platte dem Umgebungsmilieu aussetzt; und
eine MEMS-Elektrode (104), die mit der flexiblen Platte gekoppelt und elektrisch mit dem zumindest einem Abstandhalter gekoppelt ist, wobei eine Kraft (102), die auf die flexible Platte wirkt, eine Änderung in einem Spalt zwischen der MEMS-Elektrode und der zumindest einen Elektrode bewirkt.

2. MEMS-Vorrichtung (100) nach Anspruch 1, wobei der zumindest eine Abstandhalter (110) den Spalt zwischen der MEMS-Elektrode (104) und der zumindest einen Elektrode (118) definiert.

3. MEMS-Vorrichtung (100) nach Anspruch 2, wobei zumindest ein Abschnitt der unteren Fläche (108) der flexiblen Platte eine Fläche eines abgedichteten Hohlraumes (120) ist und zumindest ein Abschnitt der oberen Fläche (106) der flexiblen Platte einem Umgebungsmilieu ausgesetzt ist.

4. MEMS-Vorrichtung (100) nach Anspruch 2, wobei die Kraft (102) aus einer Differenz zwischen Umgebungsdruck und Druck in einem abgedichteten Hohlraum (120) resultiert.

5. MEMS-Vorrichtung (100) nach Anspruch 1, wobei die MEMS-Elektrode (104) ein Abschnitt der unteren Oberfläche (108) ist.

6. MEMS-Vorrichtung (100) nach Anspruch 2, wobei der zumindest eine Abstandhalter (110) elektrisch mit dem IC-Substrat (114) gekoppelt ist.

7. MEMS-Vorrichtung (100) nach Anspruch 6, wobei die MEMS-Unterbaugruppe durch eine eutektische Aluminium-Germanium-Bindung (112) an das IC-Substrat (114) gebunden ist.

8. MEMS-Vorrichtung (100) nach Anspruch 1, wobei die MEMS-Elektrode (104) über der zumindest einen Elektrode (118) getrennt durch den Spalt angeordnet ist.

9. MEMS-Vorrichtung (100) nach Anspruch 1, wobei ein abgedichteter Hohlraum (120) durch Abschnitte der unteren Oberfläche (108), des zumindest einen Abstandhalters (110) und des IC-Substrats (114) gebildet ist.

10. MEMS-Vorrichtung (100) nach Anspruch 9, wobei der abgedichtete Hohlraum (120) ferner durch die Bindung (112) zwischen dem zumindest einen Abstandhalter (110) und dem IC-Substrat (114) gebildet ist.

11. MEMS-Vorrichtung (100) nach Anspruch 9, wobei der abgedichtete Hohlraum (120) bei einem festen Druck abgedichtet ist.

12. MEMS-Vorrichtung (100) nach Anspruch 1, wobei ein Abschnitt der unteren Oberfläche (108) eine Oberfläche eines abgedichteten Hohlraumes (120) ist.

13. MEMS-Vorrichtung (100) nach Anspruch 1, ferner beinhaltend eine dielektrische Schicht (1302), die auf dem elektrischen Schaltungssubstrat (114) angeordnet ist, wobei ein Abstand zwischen der MEMS-Elektrode (104) und der dielektrischen Schicht kleiner ist als ein Abstand zwischen der MEMS-Elektrode und der zumindest einen Elektrode (118).

14. MEMS-Vorrichtung (100) nach Anspruch 13, wobei die dielektrische Schicht (1302) und die zumindest eine Elektrode (118) seitlich angeordnet sind, oder wobei die dielektrische Schicht über der zumindest einen Elektrode angeordnet ist.

15. MEMS-Vorrichtung (100) nach Anspruch 1, wobei der zumindest eine Abstandhalter (110) durch eine eutektische Aluminium-Germanium-Bindung (112) an das IC-Substrat (114) gebunden ist.

**Revendications**

1. Dispositif à systèmes microélectromécaniques (MEMS) (100) comprenant :

   un substrat de circuit intégré (114) ;
   au moins une électrode (118) disposée sur le substrat de circuit intégré ;
   un sous-ensemble MEMS couplé au substrat de circuit intégré,
   le sous-ensemble MEMS comprenant au moins une entretoise (110) ;
   une plaque flexible (126) avec une surface supérieure (106) et une surface inférieure (108) ;
   un substrat de manipulation (122),
   la plaque flexible étant formée sur une couche de dispositif et étant liée au substrat de manipulation,
   une ouverture dans le substrat de manipulation exposant au moins une partie de la surface supérieure de la plaque flexible à l'environnement ambiant ; et
   une électrode MEMS (104) couplée à la plaque flexible et couplée électriquement à l'au moins une entretoise,
   une force (102) agissant sur la plaque flexible provoquant un changement dans l'intervalle entre l'électrode MEMS et l'au moins une électrode.

2. Dispositif MEMS (100) selon la revendication 1, dans lequel l'au moins une entretoise (110) définit l'intervalle entre l'électrode MEMS (104) et l'au moins une électrode (118).

3. Dispositif MEMS (100) selon la revendication 2, dans lequel au moins une partie de la surface inférieure (108) de la plaque flexible est une surface d'une cavité scellée de manière étanche (120) et au moins une partie de la surface supérieure (106) de la plaque flexible est exposée à un environnement ambiant.

4. Dispositif MEMS (100) selon la revendication 2, dans lequel la force (102) résulte d'une différence entre une pression ambiante et une pression dans une cavité scellée de manière étanche (120).

5. Dispositif MEMS (100) selon la revendication 1, dans lequel l'électrode MEMS (104) est une partie de la surface inférieure (108).

6. Dispositif MEMS (100) selon la revendication 2, dans lequel l'au moins une entretoise (110) est couplée électriquement au substrat de circuit intégré (114).

7. Dispositif MEMS (100) selon la revendication 6, dans lequel le sous-ensemble MEMS est lié au substrat de circuit intégré (114) par une liaison eutectique aluminium-germanium (112).

8. Dispositif MEMS (100) selon la revendication 1, dans lequel l'électrode MEMS (104) est disposée au-dessus de l'au moins une électrode (118), séparées par l'intervalle.

9. Dispositif MEMS (100) selon la revendication 1, dans lequel une cavité scellée de manière étanche (120) est formée par des parties de la surface inférieure (108), de l'au moins une entretoise (110) et du substrat de circuit intégré (114).

10. Dispositif MEMS (100) selon la revendication 9, dans lequel la cavité scellée de manière étanche (120) est en outre formée par la liaison (112) entre l'au moins une entretoise (110) et le substrat de circuit intégré (114).

11. Dispositif MEMS (100) selon la revendication 9, dans lequel la cavité scellée de manière étanche (120) est scellée de manière étanche à une pression fixe.

12. Dispositif MEMS (100) selon la revendication 1, dans lequel une partie de la surface inférieure (108) est une surface d'une cavité scellée de manière étanche (120).

13. Dispositif MEMS (100) selon la revendication 1, comprenant en outre une couche diélectrique (1302) disposée sur le substrat de circuit électrique (114), une distance entre l'électrode MEMS (104) et la couche diélectrique étant inférieure à une distance entre l'électrode MEMS et l'au moins une électrode (118).

14. Dispositif MEMS (100) selon la revendication 13, dans lequel la couche diélectrique (1302) et l'au moins une électrode (118) sont disposées latéralement, ou dans lequel la couche diélectrique est disposée au-dessus de l'au moins une électrode.

**15.** Dispositif MEMS (100) selon la revendication 1, dans lequel l'au moins une entretoise (110) est liée au substrat de circuit intégré (114) par une liaison eutectique aluminium-germanium.

FIG. 1

FIG. 2

100'

MEMS
ELECTRODE
104

TOP
SURFACE
106

BOTTOM
SURFACE
108

FORCE 102

122                                                                                          122

HANDLE
SUBSTRATE

HANDLE
SUBSTRATE

124                                                                                 124 OXIDE

120                                                                                 110 STANDOFF

BOND 112

FLEXIBLE PLATE

SEALED CAVITY                                                                      112

126

IC SUBSTRATE

ELECTRONIC CIRCUIT

114                                                                 118
                                                            FIXED ELECTRODE
116

EP 2 727 132 B1

FIG. 3

FIG. 4

EP 2 727 132 B1

500

PRESSURE PORT
510

508

508

506

UCAV

SENSOR #1; FOR EXAMPLE
GYROSCOPE

OXIDE
520

524

504

FLEXIBLE PLATE

512

522

C3(P)

Med

STDOFF

REF P

AS1

AS2

ST

C1(P)

C2

C4

CP

CMOS

502

FIG. 5

VOUT

Cf

Cf

Cp

AS1

C1(P)

C3(P)

C2

C4

AS2

ST

CP

ENABLE THE
SELF TEST

550

FIG. 6

EP 2 727 132 B1

PRESSURE PORT / PARTICLE FILTER
710

OXIDE

508'
512'
504'
508'
506'
502'

UCAV
SENSOR #1 FOR EXAMPLE GYROSCOPE

FLEXIBLE PLATE
STDOFF
REF P
C1(P) C2 C4 C3(P)
AS1 AS2
CMOS

700

FIG. 7

PRESSURE PORT / PARTICLE FILTER / STATIONARY ELECTRODE

OXIDE

STDOFF

FLEXIBLE PLATE

REF P

CMOS

AS1

AS2

C2(P)

C1(P)

C3

C4

800

808

810

812

808

806

804

802

850

Cf

Cf

VOUT

AS2

AS1

C2(P)

C1(P)

C4

C3

FIG. 8

FIG. 9

EP 2 727 132 B1

FIG. 10

FIG. 11

EP 2 727 132 B1

FIG. 12

EP 2 727 132 B1

HANDLE SUBSTRATE    DIELECTRIC 1302    PRESSURE PORT    HANDLE SUBSTRATE

FLEXIBLE PLATE

STANDOFF

IC SUBSTRATE

FIG. 13

HANDLE SUBSTRATE    PRESSURE PORT    HANDLE SUBSTRATE

1402    1402

1404    FLEXIBLE PLATE    1404 STANDOFF

IC SUBSTRATE

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61502616 A
- US 61502603 A
- EP 1860417 A